# EUROPÄISCHE PATENTANMELDUNG

(11) **EP 4 184 375 A1**
(43) Veröffentlichungstag der Anmeldung: **24.05.2023**
(21) Anmeldenummer: 21209528.5
(22) Anmeldetag: 22.11.2021
(51) Int. Cl.: G06F 30/20

(54) **VALIDIERUNG EINES COMPUTERGESTÜTZTEN SIMULATIONSMODELLS**

(71) Anmelder: Siemens Aktiengesellschaft, 80333 München (DE)
(72) Erfinder: Boschert, Stefan, 85579 Neubiberg (DE); Hartmann, Dirk, 85617 Aßling (DE); Schenk, Tim, 84034 Landshut (DE)
(74) Vertreter: Siemens Patent Attorneys

(57) **Zusammenfassung**

Die Erfindung betrifft eine Vorrichtung (100) zum Validieren eines computergestützten Simulationsmodells (DT) für ein technisches System (TS). Die Vorrichtung umfasst:
a) eine erste Schnittstelle (101), die derart eingerichtet ist, das computergestützte Simulationsmodell (DT) und einen dem computergestützten Simulationsmodell eindeutig zugeordneten Spezifikationsdatensatz (SPEC), der mindestens ein Attribut (A1, A2, A3, ...) des computergestützten Simulationsmodells spezifiziert, einzulesen, wobei das computergestützte Simulationsmodell eingerichtet ist, ein technisches Verhalten des technischen Systems (TS) zu modellieren,
b) einen Testgenerator (102), der derart eingerichtet ist, einen Testdatensatz (TC) in Abhängigkeit des Spezifikationsdatensatzes bereitzustellen, wobei der Testdatensatz für eine Validierung des Attributs (A1, A2, A3,...) geeignet ist,
c) einen Simulator (103), der derart eingerichtet ist, das computergestützte Simulationsmodell (DT) anhand des Testdatensatzes (TC) auszuführen und mindestens einen Ausgabewert (OUT) als Ergebnis der Ausführung des computergestützten Simulationsmodells auszugeben,
d) ein Prüfmodul (104), das derart eingerichtet ist, den mindestens einen Ausgabewert (OUT) anhand mindestens eines vorgegebenen Sollwerts (SV) zu validieren und ein Validierungsergebnis (VAL) auszugeben, und
e) eine zweite Schnittstelle, die derart eingerichtet ist, das computergestützte Simulationsmodell bei einem positiven Validierungsergebnis auszugeben.

## Beschreibung

Die Erfindung betrifft eine Vorrichtung und ein computergestütztes Verfahren zum Validieren eines computergestützten Simulationsmodells für ein technisches System, sowie ein Computerprogrammprodukt.

Digitale Zwillinge bzw. computergestützte Simulationsmodelle von technischen Systemen können für einen gesamten Betriebs- und Produktionszyklus genutzt werden. Dabei kann es nützlich sein, wenn die digitalen Zwillinge zwischen verschiedenen Nutzern ausgetauscht werden können. Allerdings ist ein jeweiliger digitaler Zwilling in der Regel spezifisch für ein technisches System konfiguriert, modelliert ein sehr spezifisches Verhalten und/oder kann nur unter vorgegebenen Bedingungen ausgeführt werden etc. Ein Nutzer, der einen digitalen Zwilling eines technischen Systems nutzen möchte, muss sicherstellen, dass eine funktionale Integrität und/oder Qualität des digitalen Zwillings gewährleistet ist. Beispielsweise könnte eine Verwendung eines digitalen Zwillings, der vorgegebene Spezifikationen nicht einhält, zu Schäden am realen, technischen System führen. Gegenwärtig wird insbesondere auf wenige funktionale Schnittstellenstandards, wie z.B. Functional Mockup Interface (FMI), gesetzt, die unter anderem sicherstellen, dass ein digitaler Zwilling auf einfach Weise in ein Zielsystem integriert und ausgeführt werden kann.

Es ist daher eine Aufgabe der Erfindung, die Qualität und/oder die funktionale Integrität eines bereitgestellten digitalen Zwillings bzw. eines computergestützten Simulationsmodells vor einer Verwendung zu prüfen.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt. Gemäß einem ersten Aspekt betrifft die Erfindung eine Vorrichtung zum Validieren eines computergestützten Simulationsmodells für ein technisches System, wobei die Vorrichtung umfasst:
a) eine erste Schnittstelle, die derart eingerichtet ist, das computergestützte Simulationsmodell und einen dem computergestützten Simulationsmodell eindeutig zugeordneten Spezifikationsdatensatz, der mindestens ein Attribut des computergestützten Simulationsmodells spezifiziert, einzulesen, wobei das computergestützte Simulationsmodell eingerichtet ist, ein technisches Verhalten des technischen Systems zu modellieren,
b) einen Testgenerator, der derart eingerichtet ist, einen Testdatensatz in Abhängigkeit des Spezifikationsdatensatzes bereitzustellen, wobei der Testdatensatz für eine Validierung des Attributs geeignet ist,
c) einen Simulator, der derart eingerichtet ist, das computergestützte Simulationsmodell anhand des Testdatensatzes auszuführen und mindestens einen Ausgabewert als Ergebnis der Ausführung des computergestützten Simulationsmodells auszugeben,
d) ein Prüfmodul, das derart eingerichtet ist, den mindestens einen Ausgabewert anhand mindestens eines vorgegebenen Sollwerts zu validieren und ein Validierungsergebnis auszugeben, und
e) eine zweite Schnittstelle, die derart eingerichtet ist, das computergestützte Simulationsmodell bei einem positiven Validierungsergebnis auszugeben.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "rechnergestützt" oder "computergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter einem Prozessor kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) oder einen Grafikprozessor GPU (Graphic Processing Unit) handeln. Auch kann unter einem Prozessor ein virtualisierter Prozessor, eine virtuelle Maschine oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens, der Komponente, der Module, oder anderer Aspekte und/oder Teilaspekte der Erfindung realisiert.

Unter einer "Speichereinheit" oder einem "Speichermodul" und dergleichen kann im Zusammenhang mit der Erfindung beispielsweise ein flüchtiger Speicher in Form von Arbeitsspeicher (engl. Random-Access Memory, RAM) oder ein dauerhafter Speicher wie eine Festplatte oder ein Datenträger verstanden werden.

Unter einem "Modul" kann im Zusammenhang mit der Erfindung beispielsweise ein Prozessor und/oder eine Speichereinheit zum Speichern von Programmbefehlen verstanden werden. Beispielsweise ist der Prozessor speziell dazu eingerichtet, die Programmbefehle derart auszuführen, damit der Prozessor Funktionen ausführt, um das erfindungsgemäße Verfahren oder einen Schritt des erfindungsgemäßen Verfahrens zu implementieren oder realisieren.

Unter einem "computergestützten Simulationsmodell" eines technischen Systems kann insbesondere ein digitaler Zwilling des technischen Systems verstanden werden. Das computergestützte Simulationsmodell ist insbesondere dazu eingerichtet, ein technisches, chemisches und/oder physikalisches Verhalten des technischen Systems abzubilden bzw. zu modellieren.

Unter einem "Attribut" des computergestützten Simulationsmodells kann insbesondere eine Einheit wie beispielsweise Name, Größe, Farbe, Typ, Zustand usw., oder ein Merkmal, eine Charakteristik und/oder eine Konfiguration des computergestützten Simulationsmodells verstanden werden.

Unter einem "technischen System" kann insbesondere eine Maschine, wie z.B. eine Werkzeugmaschine oder ein Roboter, ein Gerät, wie z.B. ein Feldgerät, eine industrielle Anlage, wie z.B. eine Produktionsanlage, verstanden werden.

Unter einem "Testdatensatz" kann insbesondere ein Testszenario oder Testfall (engl. Test case) verstanden werden. Ein Testdatensatz ist vorzugsweise auf mindestens ein Attribut des computergestützten Simulationsmodells gerichtet.

Es ist ein Vorteil der vorliegenden Erfindung, dass digitale Zwillinge vor einem Austausch und/oder einer Verwendung zunächst automatisch validiert werden können. Dabei wird insbesondere validiert, ob bei einer Ausführung des computergestützten Simulationsmodell vorgegebene Werte mindestens eines Attributs des Simulationsmodells eingehalten werden. Die erfindungsgemäße Vorrichtung kann beispielsweise als Teil einer Plattform zum Bereitstellen und zum Austausch von digitalen Zwillingen realisiert werden. So kann beispielsweise der Austausch und die Nutzung von digitalen Zwillingen ausgebaut/erweitert werden. Die Validierung garantiert, dass ein digitaler Zwilling vorgegebene Anforderungen gemäß einer zugeordneten Spezifikation erfüllt. Somit ist beispielsweise kein bilateraler Vertrag zwischen Bereitsteller und Nutzer eines digitalen Zwillings mehr nötig, der die Einhaltung der Spezifikation bestätigt.

In einer vorteilhaften Ausführungsform umfasst die Vorrichtung weiter eine Zertifizierungseinheit, die derart eingerichtet ist, bei einem positiven Validierungsergebnis ein Zertifikat für das computergestützte Simulationsmodell auszugeben.

Vorzugsweise kann somit ein Zertifikat für das computergestützte Simulationsmodell ausgegeben werden, in welchem bestätigt wird, dass das computergestützte Simulationsmodell die jeweils zugeordneten Spezifikationsanforderungen erfüllt. Ein Zertifikat kann beispielsweise als ein digitales/elektronische Zertifikat ausgestaltet sein. Außerdem kann ein Zertifikat von einer berechtigten Zertifizierungseinheit oder einer Zertifizierungsstelle/Zertifizierungsbehörde ausgestellt und derart der Zertifizierungseinheit bereitgestellt werden. Das Zertifikat kann außerdem digital signiert bereitgestellt werden.

In einer Ausführungsform der Vorrichtung kann das Zertifikat mit dem computergestützten Simulationsmodell und/oder dem Testdatensatz verknüpft sein.

Das Zertifikat kann eine Verknüpfung zum Simulationsmodell und/oder den Testdatensatz umfassen. Beispielsweise kann eine solche Verknüpfung eine Prüfsumme, wie z.B. einen Hash-Wert, über das Simulationsmodell und/oder den Testdatensatz oder eine eindeutige Kennung/Identifikationsnummer des computergestützten Simulationsmodells und/oder des Testdatensatzes sein. Das Zertifikat ist damit an das Simulationsmodell und/oder an den Testdatensatz gebunden. Damit kann eine eindeutige Zuordnung des Zertifikats zu dem jeweiligen Simulationsmodell und/oder Testdatensatz erzielt werden. Außerdem kann sichergestellt werden, dass definierte und reproduzierbare Bedingungen für das Ausstellen des Zertifikats vorliegen.

In einer vorteilhaften Ausführungsform der Vorrichtung kann das mindestens eine Attribut eine Ausführungsleistung des computergestützten Simulationsmodells bei Ausführung auf einer vorgegebenen Hardware, eine physikalische Eigenschaft des technischen Systems, die durch das computergestützte Simulationsmodell ausgewertet wird, einen Zustand des technischen Systems, der durch das computergestützte Simulationsmodell modelliert wird, und/oder einen Eingabeparameter des computergestützten Simulationsmodells beschreiben.

Das computergestützte Simulationsmodell ist somit vorzugsweise durch Attribute charakterisiert.

In einer weiteren Ausführungsform der Vorrichtung kann der Testdatensatz durch den Spezifikationsdatensatz definiert sein.

Dies ist vorteilhaft, da benötigte Testdaten bereits im Spezifikationsdatensatz definiert sind. Dadurch kann eine Überprüfung des computergestützten Simulationsmodells auf einfache Weise durchgeführt werden. Beispielsweise kann der Testdatensatz im Spezifikationsdatensatz gespeichert sein. Es ist auch denkbar, dass der Spezifikationsdatensatz auf den Testdatensatz verweist, wie z.B. mittels einer Verknüpfung/eines Links zu einem Speicherort des Testdatensatzes.

In einer weiteren Ausführungsform der Vorrichtung kann der Testgenerator derart eingerichtet sein, den Testdatensatz mittels eines ersten trainierten maschinellen Lernmodells bereitzustellen, wobei das erste maschinelle Lernmodell darauf trainiert ist, anhand eines Attributs eines Spezifikationsdatensatzes, der einem computergestützten Simulationsmodell eindeutig zugeordnet ist, einen Testdatensatz aus einer Menge von Testdatensätzen zu selektieren.

Dies ist vorteilhaft, da anhand eines vorliegenden Attributs ein geeigneter Testdatensatz bestimmt und bereitgestellt werden kann. Somit ist es in diesem Fall nicht nötig, dass ein Testdatensatz vorab bestimmt ist.

In einer weiteren Ausführungsform der Vorrichtung kann der Simulator derart eingerichtet sein, das computergestützte Simulationsmodell in einer vorgegebenen Hardware-Simulationsumgebung oder in einer virtuellen Hardware-Simulationsumgebung auszuführen.

Dies ermöglicht insbesondere die Überprüfung einer im Spezifikationsdatensatz vorgegebenen Rechendauer oder Ausführleistung des computergestützten Simulationsmodells.

In einer weiteren Ausführungsform der Vorrichtung kann der mindestens eine Sollwert durch den Spezifikationsdatensatz bestimmt sein.

Vorzugsweise kann im Spezifikationsdatensatz ein Erwartungs- oder Sollwert des Ergebnisses der Ausführung des computergestützten Simulationsmodells gespeichert sein. Der Sollwert ist insbesondere für ein jeweiliges Attribut definiert.

In einer weiteren Ausführungsform der Vorrichtung kann der mindestens eine Sollwert durch eine Ausführung eines weiteren computergestützten Simulationsmodells bestimmt sein, wobei das weitere computergestützte Simulationsmodell derart eingerichtet ist, das technische Verhalten des technischen Systems zu repräsentieren.

Beispielsweise kann somit durch ein ähnliches computergestütztes Simulationsmodell ein Sollwert bestimmt werden.

In einer weiteren Ausführungsform kann die Vorrichtung weiter ein Analysemodul umfassen, das derart eingerichtet ist, den mindestens einen Sollwert mittels eines zweiten trainierten maschinellen Lernmodells zu ermitteln, wobei das zweite maschinelle Lernmodell darauf trainiert ist, anhand eines Spezifikationsdatensatzes eines computergestützten Simulationsmodells einen Sollwert als Ausgabewert des computergestützten Simulationsmodells auszugeben.

So kann beispielsweise mittels des zweiten maschinellen Lernmodells anhand eines Spezifikationsdatensatzes des computergestützten Simulationsmodells ein Sollwert mit einer gewissen Wahrscheinlichkeit ausgegeben werden.

Gemäß einem zweiten Aspekt betrifft die Erfindung ein computerimplementiertes Verfahren zum Validieren eines computergestützten Simulationsmodells für ein technisches System, umfassend folgende Verfahrensschritte:
a) Einlesen eines computergestützten Simulationsmodells und eines, dem computergestützten Simulationsmodell eindeutig zugeordneten Spezifikationsdatensatzes, der mindestens ein Attribut des computergestützten Simulationsmodells spezifiziert, wobei das computergestützte Simulationsmodell eingerichtet ist, ein technisches Verhalten des technischen Systems zu modellieren,
b) Bereitstellen eines Testdatensatzes in Abhängigkeit des Spezifikationsdatensatzes, wobei der Testdatensatz für eine Validierung des Attributs geeignet ist,
c) Ausführen des computergestützten Simulationsmodells anhand des Testdatensatzes,
d) Ausgeben mindestens eines Ausgabewerts als Ergebnis der Ausführung des computergestützten Simulationsmodells,
e) Validieren des mindestens einen Ausgabewerts anhand mindestens eines vorgegebenen Sollwerts und Ausgeben eines Validierungsergebnisses,
   und
f) Ausgeben des computergestützten Simulationsmodells bei einem positiven Validierungsergebnis.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele der erfindungsgemäßen Vorrichtung und des erfindungsgemäßen Verfahrens sind in den Zeichnungen beispielhaft dargestellt und werden anhand der nachfolgenden Beschreibung näher erläutert. Es zeigen:
- Fig. 1:: ein Ausführungsbeispiel der erfindungsgemäßen Vorrichtung zum Validieren eines computergestützten Simulationsmodells für ein technisches System; und
- Fig. 2:: ein Ausführungsbeispiel des erfindungsgemäßen computerimplementierten Verfahrens zum Validieren eines computergestützten Simulationsmodells für ein technisches System.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

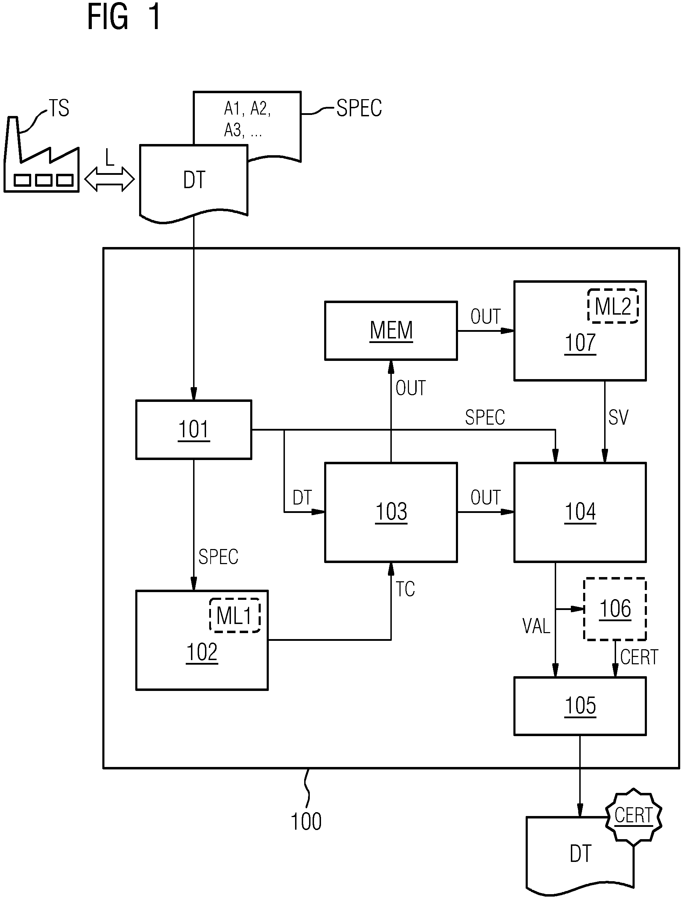

Figur 1 zeigt ein Ausführungsbeispiel der erfindungsgemäßen Vorrichtung 100 zum Validieren eines computergestützten Simulationsmodells DT für ein technisches System TS. Das computergestützte Simulationsmodell kann insbesondere auch als digitaler Zwilling des technischen Systems TS bezeichnet werden. Vorzugsweise ist das computergestützte Simulationsmodell DT zum computergestützten Abbilden/Modellieren des technischen Systems TS geeignet. Der digitale Zwilling DT ist dem technischen System TS insbesondere zugeordnet L.

Beispielsweise kann es sich bei dem technischen System TS um eine industrielle Produktionsanlage handeln. Der digitale Zwilling der Prozessanlage kann beispielsweise Prozessschritte der Produktion der industriellen Anlage abbilden.

Alternativ kann es sich bei dem technischen System TS auch um eine Maschine, wie z.B. eine Werkzeugmaschine oder ein Motor, handeln. Der digitale Zwilling der Maschine kann beispielsweise ein physikalisches Verhalten der Maschine modellieren.

Die Vorrichtung 100 kann beispielsweise als Teil oder gekoppelt mit einer Plattform (engl. Marketplace) zum Bereitstellen oder zum Austausch digitaler Zwillinge realisiert werden.

Das computergestützte Simulationsmodell DT wird zusammen mit einem dem computergestützten Simulationsmodell zugeordneten Spezifikationsdatensatz SPEC bereitgestellt. Der Spezifikationsdatensatz SPEC kann beispielsweise als Datenstruktur vorliegen, wie z.B. als Textdokument. Vorzugsweise ist der Spezifikationsdatensatz SPEC dem computergestützten Simulationsmodell eindeutig zugeordnet, wie z.B. über einen Identifikator des computergestützten Simulationsmodells, der im Spezifikationsdatensatz SPEC gespeichert ist.

Der Spezifikationsdatensatz SPEC umfasst mindestens ein Attribut A1, A2, A3 des computergestützten Simulationsmodells. Beispielsweise spezifiziert der Spezifikationsdatensatz SPEC das mindestens eine Attribut A1, A2, A3 des computergestützten Simulationsmodells. Ein Attribut beschreibt vorzugsweise eine Ausführungsleistung des computergestützten Simulationsmodells bei Ausführung auf einer vorgegebenen Hardware, eine physikalische Eigenschaft des technischen Systems, die durch das computergestützte Simulationsmodell ausgewertet wird, einen Zustand des technischen Systems, der durch das computergestützte Simulationsmodell modelliert wird, und/oder einen Eingabeparameter des computergestützten Simulationsmodells. Der Spezifikationsdatensatz SPEC beschreibt folglich in formaler Spezifikationssprache alle Attribute und/oder Merkmale des digitalen Zwillings. Der Spezifikationsdatensatz SPEC ist vorzugsweise derart ausgestaltet, dass er maschinenlesbar ist.

Der Spezifikationsdatensatz SPEC kann außerdem mindestens einen Testdatensatz TC umfassen und/oder auf einen Testdatensatz TC verweisen. Ein Testdatensatz TC bezieht sich vorzugsweise auf mindestens ein Attribut des computergestützten Simulationsmodells DT. Vorzugsweise ist der Testdatensatz TC dazu geeignet, das Attribut zu validieren.

Beispielsweise kann ein Testdatensatz TC bzw. Testszenario sich auf einen Zustand des technischen Systems, der durch das computergestützte Simulationsmodell modelliert wird, beziehen. Der Testdatensatz TC kann eingerichtet sein, einen Ausgabewert dieses Zustands bei Ausführung des computergestützten Simulationsmodells zu ermitteln, wobei der Ausgabewert anschließend gegenüber einem Sollwert dieses Zustands geprüft werden kann.

Der Spezifikationsdatensatz SPEC kann außerdem mindestens einen Sollwert umfassen, wobei der Sollwert ein vorgegebenes Ergebnis einer Ausführung des computergestützten Simulationsmodells DT angibt. Insbesondere kann ein jeweiliger Sollwert für ein jeweiliges Attribut definiert sein.

Beispielsweise kann es sich bei einem Attribut A1 um eine Ausführungsleistung des computergestützten Simulationsmodells handeln, die mit einem vorbestimmten Sollwert im Spezifikationsdatensatz SPEC vorgegeben ist.

Die Vorrichtung 100 umfasst eine erste Schnittstelle 101, eine zweite Schnittstelle 105, einen Testgenerator 102, einen Simulator 103, ein Prüfmodul 104 und optional eine Zertifizierungseinheit 106 und/oder ein Analysemodul 107. Außerdem kann die Vorrichtung mindestens einen Prozessor und eine Speichereinheit MEM umfassen.

Die erste Schnittstelle 101 ist derart eingerichtet, das computergestützte Simulationsmodell DT und dessen Spezifikationsdatensatz SPEC einzulesen.

Der Spezifikationsdatensatz SPEC wird an den Testgenerator 102 übermittelt. Der Testgenerator 102 ist derart eingerichtet, einen Testdatensatz TC in Abhängigkeit des Spezifikationsdatensatzes SPEC zu ermitteln. Beispielsweise kann der Testgenerator 102 einen im Spezifikationsdatensatz SPEC enthaltenen Testdatensatz TC auslesen. Der Testdatensatz TC ist dazu eingerichtet, mindestens ein Attribut A1, A2, A3, ... zu validieren.

Alternativ kann der Testgenerator ein erstes trainiertes maschinelles Lernmodell ML1 umfassen, das darauf trainiert ist, anhand eines Attributs eines Spezifikationsdatensatzes, der einem computergestützten Simulationsmodell eindeutig zugeordnet ist, einen Testdatensatz aus einer Menge von Testdatensätzen zu selektieren. Das maschinelle Lernmodell kann beispielsweise ein künstliches neuronales Netz sein. Das maschinelle Lernmodell ML1 ist beispielsweise mittels eines Trainingsdatensatzes trainiert, wobei der Trainingsdatensatz als Trainingseingabedaten eine Vielzahl an Attributen und als Trainingsausgabedaten jeweils den Attributen zugeordnete Testdatensätze umfasst. So kann der Testdatengenerator 102 anhand eines Attributs einen passenden Testdatensatz TC selektieren und bereitstellen.

Beispielsweise handelt es sich bei dem Testdatensatz TC für das Attribut A1, das die Ausführungsleistung des computergestützten Simulationsmodells DT betrifft, um ein Testszenario, das die Ausführungsleistung des computergestützten Simulationsmodells auf einer vorgegebenen Hardware überprüfen kann.

Das computergestützte Simulationsmodell DT und der Testdatensatz TC werden dem Simulator 103 übergeben. Der Simulator 103 ist dazu eingerichtet, das computergestützte Simulationsmodell DT anhand des Testdatensatzes TC, vorzugsweise auf einer entsprechend vorgegebenen Hardware, auszuführen und mindestens einen Ausgabewert OUT als Ergebnis der Ausführung des computergestützten Simulationsmodells auszugeben. Der Ausgabewert OUT bezieht sich vorzugsweise auf das zu validierende Attribut A1.

Der Simulator 103 kann insbesondere dazu eingerichtet sein, das computergestützte Simulationsmodell in einer vorgegebenen Hardware-Simulationsumgebung oder in einer virtuellen Hardware-Simulationsumgebung auszuführen. Dazu kann der Simulator 103 beispielsweise mit einer entsprechenden Hardware oder mit einer Cloudanwendung gekoppelt sein.

Der Ausgabewert OUT wird dem Prüfmodul 104 übergeben. Das Prüfmodul 104 ist dazu eingerichtet, den mindestens einen Ausgabewert OUT anhand mindestens eines vorgegebenen Sollwerts SV des jeweiligen Attributs zu validieren und ein Validierungsergebnis VAL auszugeben. Der Sollwert SV eines Attributs ist beispielsweise im Spezifikationsdatensatz SPEC enthalten.

Alternativ kann der Sollwert SV vom Analysemodul 107 bereitgestellt werden. Beispielsweise kann der Sollwert SV durch eine Ausführung eines weiteren computergestützten Simulationsmodells bestimmt sein, wobei das weitere computergestützte Simulationsmodell auch dazu eingerichtet ist, das technische Verhalten des technischen Systems TS zu modellieren. Vorzugsweise ist das weitere computergestützte Simulationsmodell dem betrachteten Simulationsmodell DT zumindest ähnlich.

Alternativ kann das Analysemodul 107 auch ein zweites trainiertes maschinelles Lernmodell ML2 umfassen, mit dem der mindestens eine Sollwert SV für das zu validierende Attribut ermittelt werden kann. Das zweite maschinelle Lernmodell ML2 ist darauf trainiert, anhand eines Spezifikationsdatensatz eines computergestützten Simulationsmodells einen Sollwert als Ausgabewert des computergestützten Simulationsmodells auszugeben. Dazu wurde das zweite maschinelle Lernmodell ML2 vorzugsweise mit einer Vielzahl von Spezifikationsdatensätzen von verschiedenen computergestützten Simulationsmodellen als Trainingseingabedaten und jeweils zugeordneten Ausgabewerten der Simulationsmodelle trainiert. In Abhängigkeit eines gegebenen Spezifikationsdatensatz kann das zweite maschinelle Lernmodell ML2 somit einen Ausgabewert bestimmen. Dieser Ausgabewert kann nachfolgend als Sollwert genutzt werden. Das Training des zweiten maschinellen Lernmodells ML2 kann beispielsweise auf dem Analysemodul 107 durchgeführt werden. Alternativ kann das zweite maschinelle Lernmodell ML2 trainiert bereitgestellt und derart vom Analysemodul 107 eingelesen werden.

Für das Training des zweiten maschinellen Lernmodells ML2 kann insbesondere auch der Ausgabewert OUT des computergestützten Simulationsmodells DT genutzt werden. Dazu kann der Ausgabewert OUT beispielsweise in einer Speichereinheit MEM zwischengespeichert werden.

Das Validierungsergebnis VAL für ein Attribut kann negativ sein, d.h. der Ausgabewert OUT des Attributs entspricht nicht dem Sollwert SV des Attributs innerhalb eines vorgegebenen Toleranzbereichs, oder positiv sein, d.h. der Ausgabewert OUT des Attributs entspricht dem Sollwert SV des Attributs innerhalb des vorgegebenen Toleranzbereichs. Der Toleranzbereich kann beispielsweise im Spezifikationsdatensatz SPEC gespeichert sein.

Falls das Validierungsergebnis VAL positiv ist, kann die Zertifizierungseinheit 106 ein Zertifikat für das computergestützte Simulationsmodell DT ausstellen. Das Zertifikat CERT kann insbesondere eine Prüfsumme über das Simulationsmodell und/oder eine Prüfsumme über den Testdatensatz TC umfassen. Vorzugsweise wird ein Zertifikat bereitgestellt, sobald der digitale Zwilling DT für alle Attribute A1, A2, A3 validiert wurde. Das Zertifikat kann beispielsweise die Integrität und/oder Qualität des computergestützten Simulationsmodells DT bestätigen. Der Zertifizierungsprozess kann beispielsweise Blockchain-basiert realisiert werden.

Die zweite Schnittstelle 105 ist derart eingerichtet, das computergestützte Simulationsmodell bei einem positiven Validierungsergebnis VAL, vorzugsweise zusammen mit dem Zertifikat, auszugeben. Beispielsweise kann das computergestützte Simulationsmodell DT lediglich bei einem positiven Validierungsergebnis bereitgestellt, freigegeben oder heruntergeladen werden.

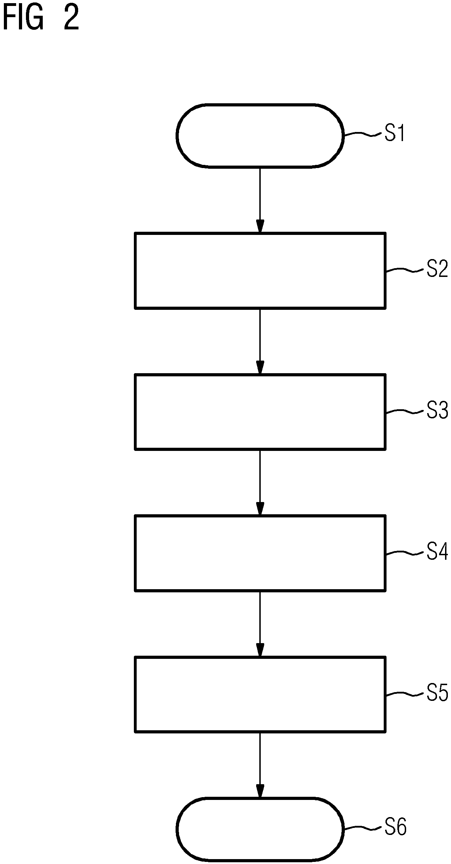

Figur 2 zeigt ein Ausführungsbeispiel eines erfindungsgemäßen, computerimplementierten Verfahrens zum Validieren eines computergestützten Simulationsmodells eines technischen Systems.

Das Verfahren umfasst die folgenden Verfahrensschritte:

Im ersten Schritt S1 wird das computergestützte Simulationsmodell und ein dem computergestützten Simulationsmodell eindeutig zugeordneter Spezifikationsdatensatz eingelesen. Der Spezifikationsdatensatz spezifiziert mindestens ein Attribut des computergestützten Simulationsmodells. Das computergestützte Simulationsmodell ist dazu eingerichtet, ein technisches Verhalten des technischen Systems zu modellieren.

Im nächsten Schritt S2 wird ein Testdatensatz in Abhängigkeit des Spezifikationsdatensatzes bereitgestellt, wobei der Testdatensatz für eine Validierung eines Werts eines Attributs geeignet ist. Beispielsweise wird anhand des Attributs im Spezifikationsdatensatz ein geeigneter Testdatensatz aus einer Menge von Testdatensätzen selektiert. Der Testdatensatz umfasst beispielsweise ein Testszenario, mit dem geprüft werden kann, ob das computergestützte Simulationsmodell bei einer Ausführung des Testszenarios die spezifizierten Attributwerte einhält.

Im nächsten Schritt S3 wird das computergestützte Simulationsmodell anhand des Testdatensatzes in einer vorgegebenen Simulationsumgebung ausgeführt. Es wird ein Testszenario ausgeführt, um anhand des Ausgabewerts des computergestützten Simulationsmodells den Wert des Attributs zu überprüfen.

Im nächsten Schritt S4 wird ein Ausgabewert des Attributs als Ergebnis der Ausführung des computergestützten Simulationsmodells ausgegeben.

Im nächsten Schritt S5 wird der Ausgabewert anhand eines vorgegebenen Sollwerts des Attributs validiert und ein entsprechendes Validierungsergebnis wird ausgegeben. Das Validierungsergebnis ist insbesondere dem entsprechenden Attribut zugeordnet.

Im nächsten Schritt S6 wird das computergestützte Simulationsmodell bei einem positiven Validierungsergebnis ausgegeben. Vorzugsweise kann bei einem positiven Validierungsergebnis ein digitales Zertifikat für das computergestützte Simulationsmodell erstellt und ausgegeben werden. Das digitale Zertifikat ist vorzugsweise dem computergestützten Simulationsmodell eindeutig zugeordnet, wie z.B. über eine Prüfsumme des computergestützten Simulationsmodells, die im Zertifikat enthalten ist.

Vorzugsweise kann das Verfahren für alle in einem Spezifikationsdatensatz angegebenen Attribute durchgeführt werden, wobei jeweils mindestens ein Testdatensatz für ein Attribut bereitgestellt wird. Die jeweiligen Validierungsergebnisse für die jeweiligen Attribute können zu einem Gesamtergebnis zusammengefasst werden. Beispielsweise kann das Zertifikat lediglich bei einem positiven Gesamtergebnis aller Validierungen ausgestellt werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Vorrichtung (100) zum Validieren eines computergestützten Simulationsmodells (DT) für ein technisches System (TS), wobei die Vorrichtung umfasst:
a) eine erste Schnittstelle (101), die derart eingerichtet ist, das computergestützte Simulationsmodell (DT) und einen dem computergestützten Simulationsmodell eindeutig zugeordneten Spezifikationsdatensatz (SPEC), der mindestens ein Attribut (A1, A2, A3, ...) des computergestützten Simulationsmodells spezifiziert, einzulesen, wobei das computergestützte Simulationsmodell eingerichtet ist, ein technisches Verhalten des technischen Systems (TS) zu modellieren,
b) einen Testgenerator (102), der derart eingerichtet ist, einen Testdatensatz (TC) in Abhängigkeit des Spezifikationsdatensatzes bereitzustellen, wobei der Testdatensatz für eine Validierung des Attributs (A1, A2, A3,...) geeignet ist,
c) einen Simulator (103), der derart eingerichtet ist, das computergestützte Simulationsmodell (DT) anhand des Testdatensatzes (TC) auszuführen und mindestens einen Ausgabewert (OUT) als Ergebnis der Ausführung des computergestützten Simulationsmodells auszugeben,
d) ein Prüfmodul (104), das derart eingerichtet ist, den mindestens einen Ausgabewert (OUT) anhand mindestens eines vorgegebenen Sollwerts (SV) zu validieren und ein Validierungsergebnis (VAL) auszugeben,
und
e) eine zweite Schnittstelle (105), die derart eingerichtet ist, das computergestützte Simulationsmodell bei einem positiven Validierungsergebnis auszugeben.

2. Vorrichtung nach Anspruch 1, weiter umfassend eine Zertifizierungseinheit (106), die derart eingerichtet ist, bei einem positiven Validierungsergebnis ein Zertifikat (CERT) für das computergestützte Simulationsmodell auszugeben.

3. Vorrichtung nach Anspruch 2, wobei das Zertifikat (CERT) mit dem computergestützten Simulationsmodell (DT) und/oder dem Testdatensatz (TC) verknüpft ist.

4. Vorrichtung nach einem der vorhergehenden Ansprüche, wobei das mindestens eine Attribut (A1, A2, A3, ...)
- eine Ausführungsleistung des computergestützten Simulationsmodells bei Ausführung auf einer vorgegebenen Hardware,
- eine physikalische Eigenschaft des technischen Systems, die durch das computergestützte Simulationsmodell ausgewertet wird,
- einen Zustand des technischen Systems, der durch das computergestützte Simulationsmodell modelliert wird,
und/oder
- einen Eingabeparameter des computergestützten Simulationsmodells beschreibt.

5. Vorrichtung nach einem der vorhergehenden Ansprüche, wobei der Testdatensatz (TC) durch den Spezifikationsdatensatz (SEPC) definiert ist.

6. Vorrichtung nach einem der vorhergehenden Ansprüche, bei der der Testgenerator (102) eingerichtet ist, den Testdatensatz (TC) mittels eines ersten trainierten maschinellen Lernmodells (ML1) bereitzustellen, wobei das erste maschinelle Lernmodell darauf trainiert ist, anhand eines Attributs eines Spezifikationsdatensatzes, der einem computergestützten Simulationsmodell eindeutig zugeordnet ist, einen Testdatensatz aus einer Menge von Testdatensätzen zu selektieren.

7. Vorrichtung nach einem der vorhergehenden Ansprüche, bei der der Simulator (103) eingerichtet ist, das computergestützte Simulationsmodell in einer vorgegebenen Hardware-Simulationsumgebung oder in einer virtuellen Hardware-Simulationsumgebung auszuführen.

8. Vorrichtung nach einem der vorhergehenden Ansprüche, bei der der mindestens eine Sollwert (SV) durch den Spezifikationsdatensatz (SPEC) bestimmt ist.

9. Vorrichtung nach einem der vorhergehenden Ansprüche, bei der der mindestens eine Sollwert (SV) durch eine Ausführung eines weiteren computergestützten Simulationsmodells bestimmt ist, wobei das weitere computergestützte Simulationsmodell derart eingerichtet ist, das technische Verhalten des technischen Systems zu repräsentieren.

10. Vorrichtung nach einem der vorhergehenden Ansprüche, weiter umfassend ein Analysemodul (107), das derart eingerichtet ist, den mindestens einen Sollwert mittels eines zweiten trainierten maschinellen Lernmodells (ML2) zu ermitteln, wobei das zweite maschinelle Lernmodell (ML2) darauf trainiert ist, anhand eines Spezifikationsdatensatzes eines computergestützten Simulationsmodells einen Sollwert als Ausgabewert des computergestützten Simulationsmodells auszugeben.

11. Computerimplementiertes Verfahren zum Validieren eines computergestützten Simulationsmodells (DT) für ein technisches System (TS), umfassend folgende Verfahrensschritte:
a) Einlesen (S1) eines computergestützten Simulationsmodells (DT) und eines dem computergestützten Simulationsmodell eindeutig zugeordneten Spezifikationsdatensatzes (SPEC), der mindestens ein Attribut (A1, A2, A3, ...) des computergestützten Simulationsmodells spezifiziert, wobei das computergestützte Simulationsmodell (DT) eingerichtet ist, ein technisches Verhalten des technischen Systems (TS) zu modellieren,
b) Bereitstellen (S2) eines Testdatensatzes (TC) in Abhängigkeit des Spezifikationsdatensatzes (SPEC), wobei der Testdatensatz für eine Validierung des Attributs geeignet ist,
c) Ausführen (S3) des computergestützten Simulationsmodells anhand des Testdatensatzes (TC),
d) Ausgeben (S4) mindestens eines Ausgabewerts (OUT) als Ergebnis der Ausführung des computergestützten Simulationsmodells,
e) Validieren (S5) des mindestens einen Ausgabewerts (OUT) anhand mindestens eines vorgegebenen Sollwerts (SV) und Ausgeben eines Validierungsergebnisses (VAL),
und
f) Ausgeben (S6) des computergestützten Simulationsmodells bei einem positiven Validierungsergebnis.

12. Computerprogrammprodukt, das direkt in einen programmierbaren Computer ladbar ist, umfassend Programmcodeteile, die dazu geeignet sind, die Schritte des computerimplementierten Verfahrens nach Anspruch 11 durchzuführen.
